# EUROPÄISCHE PATENTSCHRIFT

(11) **EP 1 342 313 B1**
(45) Veröffentlichungstag und Bekanntmachung des Hinweises auf die Patenterteilung: **17.02.2010**
(21) Anmeldenummer: 01270011.8
(22) Anmeldetag: 09.11.2001
(51) Int. Cl.: H03B 1/00

(54) **VERFAHREN UND VORRICHTUNG ZUR MILLIMETERWELLEN-LEISTUNGSREGELUNG BEI EINEM V-BAND SENDE-/EMPFANGSMODUL**
METHOD AND DEVICE FOR REGULATING THE POWER OF MILLIMETER WAVES FOR A V-BAND TR MODULE
PROCEDE ET DISPOSITIF DE REGULATION DE PUISSANCE DES ONDES MILLIMETRIQUES POUR UN MODULE TR BANDE V

(30) Priorität: 04.12.2000 DE 10060332
(43) Veröffentlichungstag der Anmeldung: 10.09.2003
(73) Patentinhaber: EADS Deutschland GmbH, 85521 Ottobrunn (DE)
(72) Erfinder: FILLEBÖCK, Marion, 89081 Ulm-Söflingen (DE); SCHROTH, Joerg, 89073 Ulm (DE)
(74) Vertreter: Meel, Thomas
(86) Internationale Anmeldenummer: PCT/DE2001/004215
(87) Internationale Veröffentlichungsnummer: WO 2002/047245

(56) Entgegenhaltungen:
- US-A- 4 837 530
- US-A- 4 843 354
- US-A- 5 878 331
- SCHINDLER M J ET AL: "DC-40 GHZ AND 20-40 GHZ MMIC SPDT SWITCHES" IEEE TRANSACTIONS ON ELECTRON DEVICES, IEEE INC. NEW YORK, US, Bd. ED-34, Nr. 12, 1. Dezember 1987 (1987-12-01), Seiten 2595-2602, XP000048066 ISSN: 0018-9383

## Beschreibung

Die Erfindung betrifft ein Verfahren und eine Vorrichtung zur Millimeterwellen-Leistungsregelung bei einem V-Band Sende-/Empfangsmodul nach dem Oberbegriff von Anspruch 1.

Die Ausgangsleistung insbesondere bei mobilen Kommunikationsgeräten sollte möglichst konstant sein, und zwar unabhängig von individuellen Eigenschaften der in großen Stückzahlen produzierten Bauelemente und Geräte. Bei Frequenzen <50GHz werden regelbare Dämpfungsglieder auf MMICs mit PIN-Dioden oder als MESFET Schalter realisiert. Aus US 5,103,195 ist ein regelbares Dämpfungsglied mit MMIC-Schaltern für eine Frequenz von bis zu 6GHz bekannt. Auch andere Leistungsregelkonzepte für niedrigere Frequenzen sind aus dem Stand der Technik bekannt. Ein V-Band Sende-/Empfangsmodul (TR-Modul) mit geregelter Ausgangsleistung ist jedoch derzeit nicht bekannt. Auch ein regelbares Dämpfungsglied bei 60GHz als MMIC ist derzeit auf dem Markt nicht erhältlich. Aus US 4,837,530 ist ein regelbares Dämpfungsglied bei DC-50 GHz als MMIC bekannt.

Die individuelle Einstellung der gefertigten Geräte ist sehr kostenintensiv; deshalb wäre es erwünscht, diese durch entsprechende Auslegung zu vermeiden. Gleichzeitig sollen möglichst wenig zusätzliche Komponenten erforderlich sein, da diese einerseits selbst wieder individuell streuen und andererseits Kosten verursachen.

Seitens der Firma United Monolithic Semiconductors S.A.S., 91401 Orsay Cedex France wird unter der Typbezeichnung "CHS2190a" ein 50-60 G Hz SPDT (=**S**ingle **P**ole **D**ouble **T**hrow) -Schalter für Kommunikationssysteme angeboten, der bereits bisher als Sende-Empfangsumschalter in Sende- Empfangsmodulen eingesetzt wurde. Aus US 5,878,331 A1 ist eine Schaltung bekannt, bei welcher SPDT- Sende-Empfangsumschalter in Sende- Empfangsmodulen eingesetzt werden. Eine weitere Sende-Empfangsumschaltung mit einem regelbaren Dämpfungsglied ist aus DE 196 44 448 A1 bekannt. Es ist das Ziel der Erfindung, unter Verwendung dieses oder eines entsprechenden Schalters eine Leistungsregelung mit den genannten Merkmalen zu schaffen.

Gemäß der Erfindung wird dies durch die Merkmale der Ansprüche 1 bzw. 2 gelöst.

Der Einsatz des SPDT MMIC als regelbares Dämpfungsglied ermöglicht die Einstellung einer gewünschten Sendeleistung und die Kompensation von Chipstreuungen. Er bildet die Kernkomponente für eine Leistungsregelung (Stellglied). Wegen der Doppelfunktion des Chips ergibt sich eine beträchtliche Kostenersparnis.

Auch die Verwendung des zweiten SPDT MMIC als Leistungsdetektor ergibt aufgrund der Doppelfunktion eine Kostenersparnis.

Insgesamt führt die Leistungsregelung für das gesamte TR-Modul zu einer Steigerung des Modul Yields durch Kompensation von Chipstreuungen und Temperatureffekten. Die Mehrfachnutzung der SPDT MMICs als Schalter, Dämpfungsglied und Leistungsdetektor führt zu den genannten Vorteilen.

Einzelheiten der Erfindung ergeben sich aus den Unteransprüchen und der Beschreibung, in der ein Ausführungsbeispiel anhand der Zeichnung erörtert wird. Es zeigen
- Fig. 1: ein Blockschaltbild der Sendeleistungsregelung nach der Erfindung
- Fig. 2: das Layout und die Padbezeichnung des bekannten SPDT MMIC,
- Fig. 3: das Prinzipschaltbild
- Fig. 4: die externe Beschaltung und DC Versorgung,
- Fig. 5: das Dämpfungsverhalten in Abhängigkeit von der Kontrollsparwung
- Fig. 6: die Verwendung des SPDT MMIC als Detektor
- Fig. 7: die maximal verfügbare und geregelte Sendeleistung

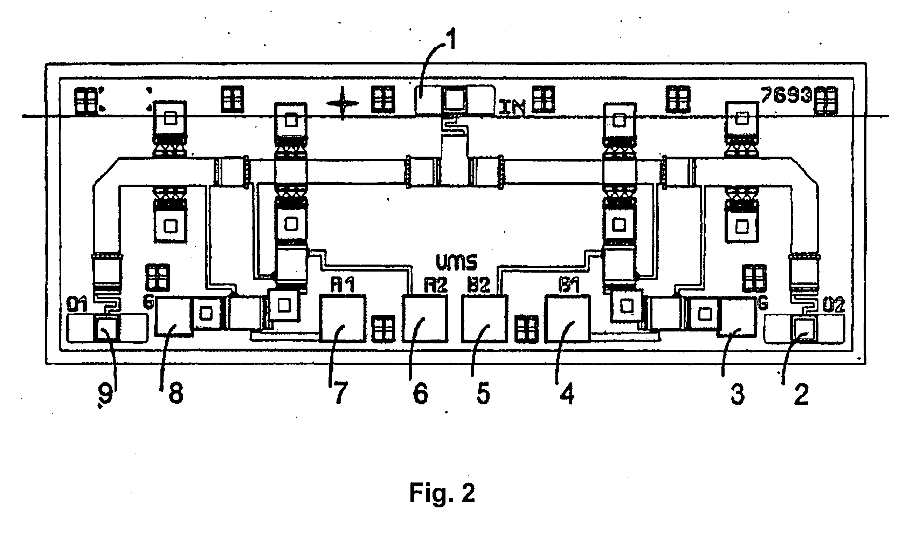

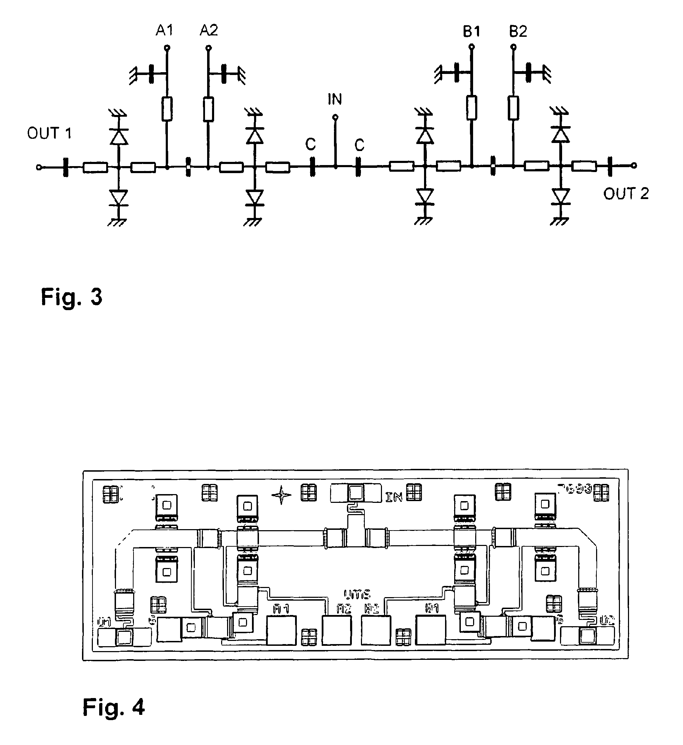

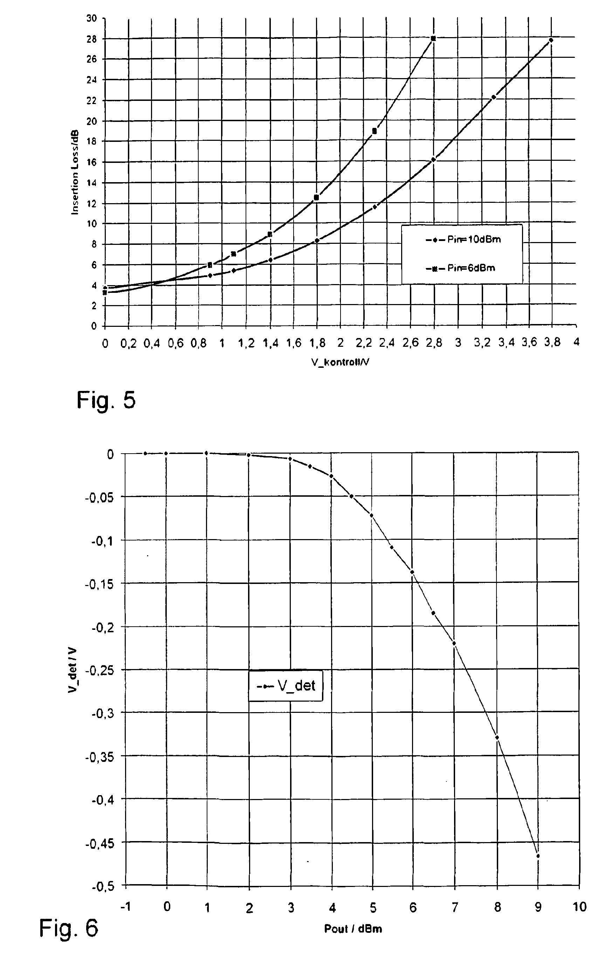

Das bekannte MMIC kann gemäß der Erfindung entweder als Schottkydiodenschalter vom Typ SPDT (Single Pole Double Throw) oder durch Wahl anderer Versorgungsspannungen als regelbares Dämpfungsglied betrieben werden. Die Figuren 2 und 3 zeigen das Layout des SPDT MMICs und ein Blockschaltbild. Bezugszeichen 1 bezeichnet den HF-Eingang (Tor IN), Bezugszeichen 9 den ersten HF-Ausgang (Tor O1) und Bezugszeichen 2 den zweiten HF-Ausgang (Tor O2). Die Bezugszeichen 4-7 bezeichnen die Bias von Dioden 1-4. Mit Bezugszeichen 3 und 8 ist jeweils Masse bezeichnet. Im Schaltbetrieb wird die Eingangsleistung am Port IN entweder auf Port 01 oder 02 durchgeschaltet. Zum Betrieb als variables Dämpfungsglied wird Tor 02 reflexionsfrei abgeschlossen und der Schaltarm IN-O2 wird in Durchlassrichtung betrieben. Zwischen den Toren IN und 01 lässt sich über die DC Versorgungsspannung eine variable Dämpfung zwischen 3,5 und 25 dB einstellen (Figuren 4 und 5).

Figur 4 zeigt eine externe Beschaltung und DC-Versorgung. Die Betriebsarten sind folgende:

### Schaltbetrieb:

Schaltarm IN-O1 in ON-Zustand, Schaltarm IN-O2 in OFF-Zustand,
Pads A1, A2: -2,5V
Pads B1, B2: 12mA
OFF-Zustand: Schaltarm sperrt
ON-Zustand: Schaltarm läßt durch

Die externe Spannungsversorgung erfolgt über Serienwiderstände von ca 250 Ohm in Serie zu den Pads A1, A2, B1, B2.

### Detektorbetrieb:

Schaltarm IN-O1 als Detektor, Schaltarm IN-O2 in OFF-Zustand:
Pads A1,A2: 0V, (1kOhm in Serie zu Pads)
Pads B1,B2: 12 mA

### Betrieb als variables Dämpfungsglied:

Schaltarm IN-O1 in ON-Zustand (Tor O1 reflexionsfrei abgeschlossen),
Schaltarm IN-O2 in Dämpfungsbetrieb:
Pads A1,A2:-2.5V
Pads B1,B2: 0 - 12 mA (entspricht 0-4 V nach Serienwiderstand 250 Ohm)

Auf dem SPDT MMIC sind auf jedem Schaltarm je zwei Diodenpaare 4/5 bzw.6/7 zwischen die HF-Leitung und Masse geschaltet. Beim Betrieb des SPDT MMICs als Leistungsdetektor wird ein Arm gesperrt (z.B. IN-O2), der zweite Arm wird mit einer Vorspannung von 0V auf Durchgang geschaltet. Die durch den ON-Arm fließende HF-Leistung wird an den parallel geschalteten Dioden gleichgerichtet. Die an den Pads A1 bzw A2 meßbare Richtspannung ist ein Maß für die durchfließende Leistung, wie in Fig. 6 dargestellt ist. Für die Leistungsmessung wird die Richtspannung am Pad A2 herangezogen. Eine Leistungdetektion am SPDT MMIC ist für Pegel 3dBm< P <10dBm möglich.

Fig. 5 zeigt das Dämpfüngsverhatten in Abhängigkeit von der Kontrollspannung. Dabei gelten folgende Werte:

### DC Beschaltung und Spannungsversorgung:

Pads A1, A1: - 2.5V
Pads B1, B2: Kontrollspannung angelegt über 250 Ohm Serienwiderstand

### HF Konfiguration:

Messung am Waferprober bei 58 GHz
Eingangsleistung am Tor IN, Ausgangsleistung am Tor 02, Tor 01 war mit einem 10 dB Dämpfungsglied abgeschlossen

Fig. 6 zeigt die Verwendung des SPDT MMIC als Detektor. In Diagramm ist die Detektorspannung in Abhängigkeit von der gemessenen Ausgangsleistung dargestellt. Dabei gelten:

### DC Beschaltung und Spannungsversorgung:

Pads A1,A2: 0V zugeführt über 1kOhm Serienwiderstand
Kontrollspannung
Pads B1, B2: 12mA

### HF Konfiguration:

Messung am Waferprober bei 58 GHz
Eingangsleistung am Tor O1, Ausgangsleistung am Tor IN, Tor 02 war mit einem 10dB Dämpfungsglied abgeschlossen

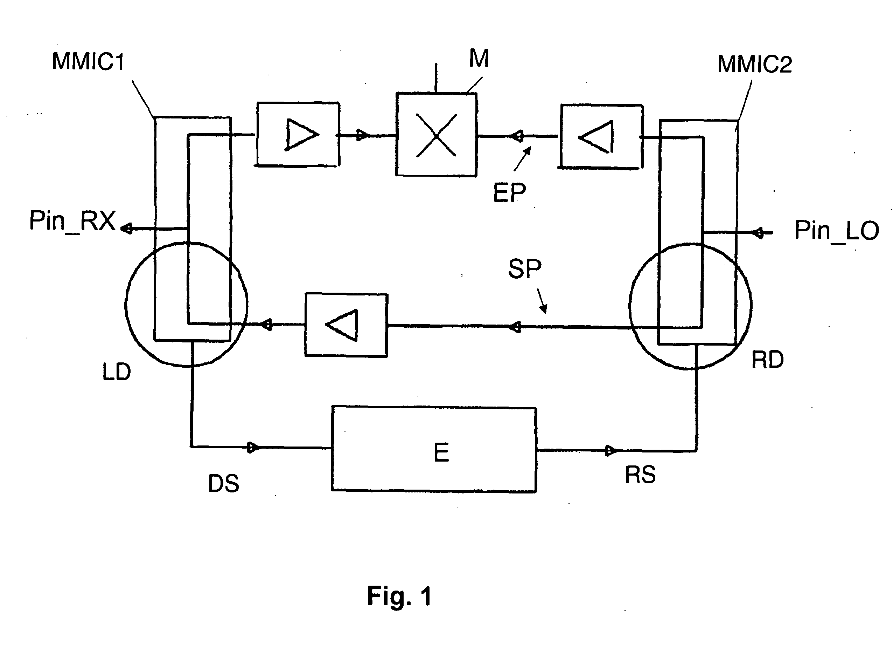

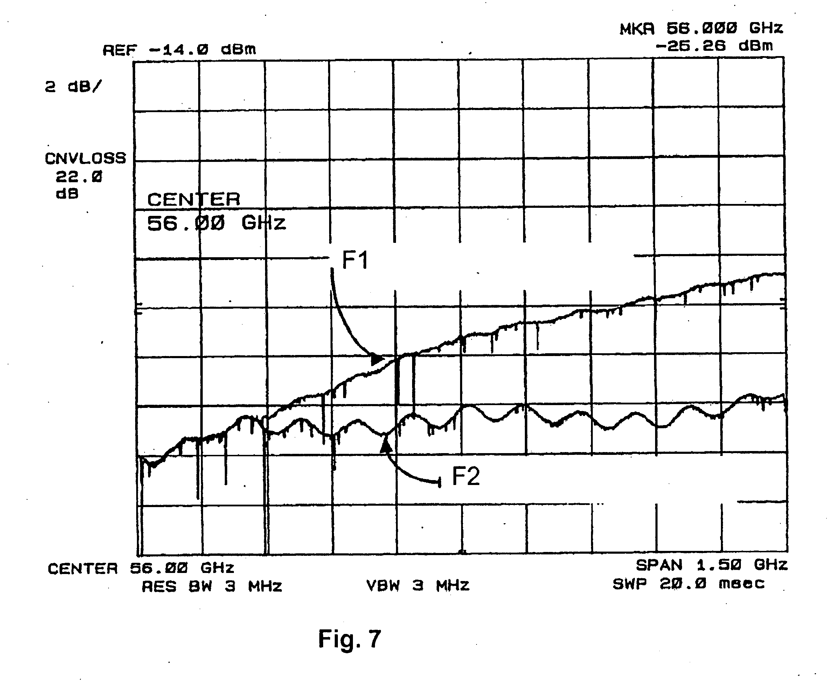

Mit den beschriebenen Komponenten wurde die erfindungsgemäße Sendeleistungsregelung für ein Sendeempfangsmodul entwickelt, wie sie im Blockschaltbild Fig. 1 zusammengestellt gezeigt wird. Im Empfangsfall werden beide SPDT MMICs (1 und 2) als Schalter verwendet. LO Leistung (Pin_LO) und Empfangsleistung (Pin_RX) werden über den Empfangspfad EP auf den Mischer M geschaltet. Im Sendefall fungiert SPDT MMIC 2 im Sendepfad SP als regelbares Dämpfungsglied RD und SPDT MMIC 1 als Leistungsdetektor LD. Der Leistungsregelkreis wird über eine analoge Elektronik E geschlossen DS ist die Detektorspannung. RS ist die Regelspannung. Über den Sollwert an der Elektronik E wird der gewünschte Ausgangspegel eingestellt. Figur 7 zeigt die am Spektrumanalysator gemessene Ausgangsleistung für den ungeregelten Fall F1 (maximal verfügbare Leistung) und den geregelten Fall F2 (Pout=5dBm=const)

## Patentansprüche

1. Verfahren zur Millimeterwellen-Leistungsregelung bei einem V-Band Sende-/Empfangsmodul bei einer Frequenz im Bereich von 50 GHz und höher, bei welchem die Umschaltung zwischen einem Sendepfad (SP) und einem Empfangspfad (EP) mit Hilfe von zwei Single Pole Double Throw MMIC Sende-/Empfangsumschalter (MMIC1, MMIC2) und die Regelung der Ausgangsleistung auf einen vorgegebenen Pegel über eine Elektronik (E) erfolgt,
**dadurch gekennzeichnet, dass**
die Sende-/Empfangsumschalter (MMIC1, MMIC2) Diodenschalter sind und im Sendefall der eine Sende-/Empfangsumschalter (MMIC2) als regelbares Dämpfungsglied (RD) und der andere Sende-/Empfangsumschalter (MMIC1) als Detektor (LD) für die Ausgangsleistung verwendet wird.

2. Sende-/Empfangsmodul für das V-Band mit Millimeterwellen-Leistungsregelung bei einer Frequenz im Bereich von 50 GHz und höher um-fassend einen Sendepfad (SP), einen Empfangspfad (EP), zwei Single Pole Double Throw MMIC Sende-/Empfangsumschalter (MMIC1, MMIC2) sowie eine elektronische Einrichtung (E) zur Einstellung der Ausgangsleistung,
**dadurch gekennzeichnet, dass**
die Sende-/Empfangsumschalter (MMIC1, MMIC2) Diodenschalter sind und
die elektronische Einrichtung (E) zur Einstellung der Ausgangsleistung mit den Sende-/Empfangsumschaltern (MMIC1, MMIC2) verbunden ist, wobei im Sendefall der eine Sende-/Empfangsumschalter (MMIC2) als regelbares Dämpfungsglied (RD) und der andere Sende-/Empfangsumschalter (MMIC1) als Detektor (LD) für die Ausgangsleistung dient.

3. Sende-/Empfangsmodul nach Anspruch 2, **dadurch gekennzeichnet, dass** ein Sende-/Empfangsumschalter (MMIC1, MMIC2) zwei Schaltarme (IN-O1, IN-O2) aufweist, wobei im Schaltbetrieb die Eingangsleistung am HF-Eingang (1, IN) wahlweise auf einen HF-Ausgang (9) in einem Schaltarm (IN-O1) oder auf einen anderen HF-Ausgang (2) im anderen Schaltarm (IN-O2) durchschaltbar ist und dass beim Betrieb als regelbares Dämpfungsglied der eine HF-Ausgang (9) reflexionsfrei abgeschlossen und zwischen dem HF-Eingang (1, IN) und dem anderen HF-Ausgang (2) über die Versorgungsspannung eine variable Dämpfung einstellbar ist.

4. Sende-/Empfangsmodul nach Anspruch 2, **dadurch gekennzeichnet, dass** beim zwei Schaltarme (IN-O1, IN-O2) aufweisenden Sende-/Empfangsumschalter (MMIC1, MMIC2) auf jedem Schaltarm (IN-O1, IN-O2) je zwei parallel geschaltete Diodenpaare (6, 7; 4, 5) zwischen den HF-Eingang (1, IN)) und Masse (8, 3) geschaltet sind und dass beim Betrieb als Leistungsdetektor der eine Schaltarm (IN-O1, IN-O2) gesperrt und der andere Schaltarm (IN-O2, IN-O1) mit einer Vorspannung von 0 V auf Durchgang geschaltet ist, dass eine durch den anderen Schaltarm (IN-O2, IN-O1) fließende HF-Leistung an den Dioden (4, 5; 6, 7) gleichgerichtet wird und die messbare Richtspannung als Maß für die durchfließende Leistung dient.

## Claims

1. Method for regulating the power of millimetric waves in a V-band transmitting/receiving module at a frequency in the region of 50 GHz or more, in which the switching between a transmission path (SP) and a reception path (EP) is carried out with the aid of two single pole double throw MMIC transmitting/receiving changeover switches (MMIC1, MMIC2), and the output power is regulated at a predetermined level via electronics (E),
**characterized in that**
the transmitting/receiving changeover switches (MMIC1, MMIC2) are diode switches, with one transmitting/receiving changeover switch (MMIC2) being used as a controllable attenuation element (RD) for transmission, and with the other transmitting/receiving changeover switch (MMIC1) being used as a detector (LD) for the output power.

2. Transmitting/receiving module for V-band with the power of millimetric waves being regulated at a frequency in the region of 50 GHz or more, comprising a transmission path (SP), a reception path (EP), two single pole double throw MMIC transmitting/receiving changeover switches (MMIC1, MMIC2) and an electronic device (E) for setting the output power,
**characterized in that**
the transmitting/receiving changeover switches (MMIC1, MMIC2) are diode switches, and the electronic device (E) is connected to the transmitting/receiving changeover switches (MMIC1, MMIC2) in order to set the output power, wherein one transmitting/receiving changeover switch (MMIC2) is used as a controllable attenuation element (RD) for transmission, and the other transmitting/receiving changeover switch (MMIC1) is used as a detector (LD) for the output power.

3. Transmitting/receiving module according to Claim 2, **characterized in that** a transmitting/receiving changeover switch (MMIC1, MMIC2) has two switching arms (IN-O1, IN-O2), wherein, during switching operation, the input power at the RF input (1, IN) can be selectively passed on to an RF output (9) in one switching arm (IN-O1) or to another RF output (2) in the other switching arm (IN-02), and **in that**, during operation as a controllable attenuation element, one RF output (9) is terminated to be free of reflections, and a variable attenuation can be set between the RF input (1, IN) and the other RF output (2) via the supply voltage.

4. Transmitting/receiving module according to Claim 2, **characterized in that** if the transmitting/receiving changeover switches (MMIC1, MMIC2) have two switching arms (IN-O1, IN-O2), two parallel-connected diode pairs (6, 7; 4, 5) are in each case connected between the RF input (1, IN) and earth (8, 3) on each switching arm (IN-O1, IN-02), and **in that**, during operation as a power detector, one switching arm (IN-O1, IN-O2) is switched off, and the other switching arm (IN-02, IN-O1) is switched on with a bias voltage of 0 V, and **in that** an RF power flowing through the other switching arm (IN-02, IN-O1) is rectified at the diodes (4, 5; 6, 7), and the measurable rectified voltage is used as a measure for the power flowing through.

## Revendications

1. Procédé de régulation de la puissance d'ondes millimétriques sur un module émetteur/récepteur en bande V à une fréquence dans la plage des 50 GHz et plus, selon lequel la commutation entre un trajet d'émission (SP) et un trajet de réception (EP) s'effectue à l'aide de deux inverseurs d'émission/réception unipolaires à deux directions MMIC (MMIC1, MMIC2) et la régulation de la puissance de sortie à un niveau prédéfini s'effectue par le biais d'un circuit électronique (E), **caractérisé en ce que** les inverseurs d'émission/réception (MMIC1, MMIC2) sont des commutateurs à diode et, dans le cas de l'émission, l'un des inverseurs d'émission/réception (MMIC2) est utilisé comme élément atténuateur réglable (RD) et l'autre inverseur d'émission/réception (MMIC1) comme détecteur (LD) de la puissance de sortie.

2. Module émetteur/récepteur pour la bande V avec régulation de la puissance d'ondes millimétriques à une fréquence dans la plage des 50 GHz et plus, comprenant un trajet d'émission (SP), un trajet de réception (EP), deux inverseurs d'émission/réception unipolaires à deux directions MMIC (MMIC1, MMIC2) ainsi qu'un dispositif électronique (E) de réglage de la puissance de sortie, **caractérisé en ce que** les inverseurs d'émission/réception (MMIC1, MMIC2) sont des commutateurs à diode et le dispositif électronique (E) est relié avec les inverseurs d'émission/réception (MMIC1, MMIC2) pour régler la puissance de sortie, dans le cas de l'émission, l'un des inverseurs d'émission/réception (MMIC2) étant utilisé comme élément atténuateur réglable (RD) et l'autre inverseur d'émission/réception (MMIC1) comme détecteur (LD) de la puissance de sortie.

3. Module émetteur/récepteur selon la revendication 2, **caractérisé en ce qu'**un inverseur d'émission/réception (MMIC1, MMIC2) présente deux branches de commutation (IN-O1, IN-O2) et, en mode commutation, la puissance d'entrée à l'entrée HF (1, IN) peut être connectée au choix à une sortie HF (9) dans une branche de commutation (IN-O1) ou à une autre sortie HF (2) dans l'autre branche de commutation (IN-O2) et que lors du fonctionnement en tant qu'élément atténuateur réglable, l'une des sorties HF (9) est terminée sans réflexion et une atténuation variable peut être réglée entre l'entrée HF (1, IN) et l'autre sortie HF (2) par le biais de la tension d'alimentation.

4. Module émetteur/récepteur selon la revendication 2, **caractérisé en ce** dans le cas de l'inverseur d'émission/réception (MMIC1, MMIC2) qui présente deux branches de commutation (IN-O1, IN-02), deux paires de diodes (6, 7 ; 4, 5) branchées en parallèle sont respectivement branchées entre l'entrée HF (1, IN) et la masse (8, 3) et que lors du fonctionnement en tant que détecteur de puissance, l'une des branches de commutation (IN-02, IN-O1) est bloquée et l'autre branche de commutation (IN-O2, IN-O1) est rendue passante avec une tension de polarisation de 0 V, qu'une puissance HF qui circule à travers l'autre branche de commutation (IN-02, IN-O1) est redressée par les diodes (4, 5 ; 6, 7) et la tension redressée mesurable est utilisée comme cote de la puissance transportée.
